Europäisches Patentamt

European Patent Office

Office européen des brevets

(11) Publication number: **0 085 624**
**B1**

# (12) EUROPEAN PATENT SPECIFICATION

(45) Date of publication of patent specification: **17.01.90**

(21) Application number: **83400200.8**

(22) Date of filing: **28.01.83**

(51) Int. Cl.$^5$: **H 01 L 27/02,** H 03 K 19/091,
H 01 L 27/06

(54) Schottky shunt integrated injection logic circuit.

(30) Priority: **02.02.82 US 345257**

(43) Date of publication of application:
**10.08.83 Bulletin 83/32**

(45) Publication of the grant of the patent:
**17.01.90 Bulletin 90/03**

(84) Designated Contracting States:
**DE FR GB IT NL**

(56) References cited:
FR-A-2 369 751

NEUES AUS DER TECHNIK, no. 2, 10th April
1978, page 3, Wuerburg, DE;
"Antisättigungsdiode für I2L"

IBM TECHNICAL DISCLOSURE BULLETIN, vol.
23, no. 9, February 1981, pages 4342-4344, New
York, US; G.C. FETH et al.: "High performance
implementation of MTL"

(73) Proprietor: **FAIRCHILD SEMICONDUCTOR
CORPORATION**
**10400 Ridgeview Court P.O. Box 1500**
**Cupertino, California 95014 (US)**

(72) Inventor: **Early, James M.**
**740 Center Drive**
**Palo Alto California 94301 (US)**

(74) Representative: **Sparing Röhl Henseler
Patentanwälte European Patent Attorneys
Rethelstrasse 123
D-4000 Düsseldorf 1 (DE)**

(56) References cited:
**IEEE JOURNAL OF SOLID-STATE CIRCUITS, vol.
SC-11, no. 5, October 1976, pages 644-647, IEEE,
New York, US; M.I. ELMASRY: "Folded-collector
integrated injection logic"**

Courier Press, Leamington Spa, England.

## Description

Background of the invention

Field of the invention

This invention relates to integrated circuit structures and specifically to an integrated injection logic circuit utilizing voltage pull-up means and current mirror connection of the switching transistor having a plurality of collectors to limit the signal swing for logic voltages, thus preventing saturation of the transistors forming the integrated injection logic circuit and thereby resulting in an integrated injection logic circuit having increased switching speeds over prior art circuits.

Description of the prior art

Circuits and structures utilizing integrated injection logic ($I^2L$) are well known in the prior art. $I^2L$ structures are particularly suited for the formation of logic gates of a type wherein each gate comprises a pair of merged complementary transistors. In such a gate, a PNP injector transistor is typically used as a current source for supplying current to the base of an NPN switching transistor. The NPN transistor often has multiple collectors which may be used to drive a plurality of other logic elements. Integrated injection logic circuits are compact, operate at very low voltages, and can be fabricated easily and inexpensively utilizing relatively few masking steps.

Integrated injection logic circuits and structures have been described in various patents and technical articles. See, for example, an article by H. H. Burger and S. K. Weidman entitled "Merged transistor Logic (MTL)—a Low-Cost Bipolar Logic Concept" and an article by K. Hart and A. Slob entitled "Integrated Injection Logic: A New Approach to LSI", both in the Journal of Solid-State Circuits, Volume SC-7, No. 5, October 1972 at pages 340—346 and pages 346—351, respectively; U.S. Patent number 4,286,177 issued August 25, 1981 to Hart and Slob; see also the article by H. H. Berger and S. K. Wiedmann, "The Bipolar Oxide Breakthrough", Parts 1 and 2, Electronics, September 4, 1975, pages 89—95 and October 2, 1975, pages 99—103, respectively; and the article by T. Poorter entitled "Electrical Parameters, Static and Dynamic Response of $I^2L$", IEEE Journal of Solid State Circuits, Vol. SC-12, No. 5, October 1977, pages 440—449; and U.S. Patent No. 3,993,513 entitled "Combined Method for Fabricating Oxide—Isolated Bipolar Transistors and Complementary Oxide—Isolated Lateral Bipolar Transistors and the Resulting Structures", assigned to Fairchild Camera and Instrument Corporation, the assignee of this application. A multiple collector structure for bipolar transistors is described in U.S. Patent No. 4,084,174 entitled "Graduated Multiple Collector Structure for Inverted Vertical Bipolar Transistors" of Crippen, Hingarh and Verhofstadt, and also assigned to Fairchild Camera and Instrument Corporation. Each of these articles and patents is hereby incorporated by reference.

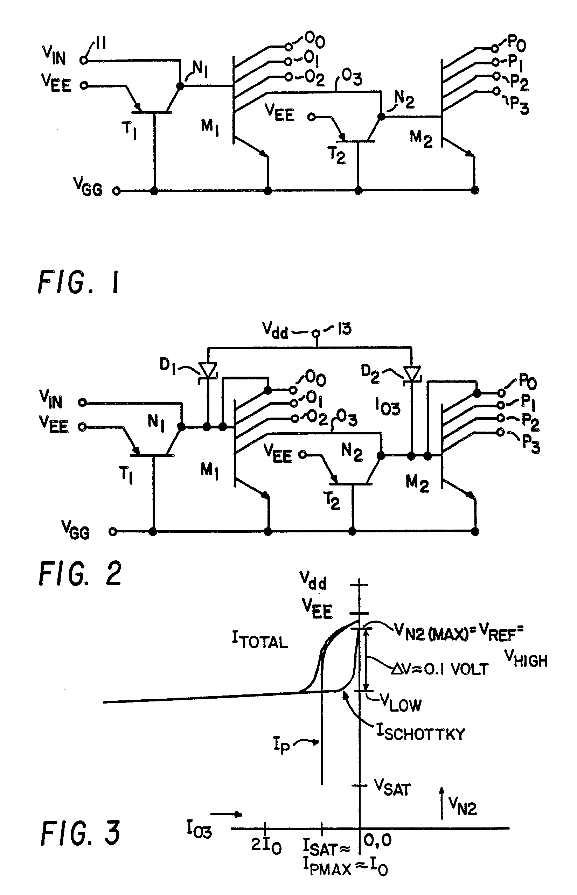

Figure 1 shows a schematic diagram of a portion of a typical prior art integrated injection logic circuit. PNP injector transistor $T_1$ serves as a current source, providing current to the base of NPN switching transistor $M_1$. The emitter of transistor $T_1$ is connected to a positive voltage source $V_{EE}$, the base of injector transistor $T_1$ is connected to ground ($V_{GG}$), and the collector of transistor $T_1$ is connected to input terminal 11, which is used for receiving an input signal $V_{in}$. The collector of transistor $T_1$ is also connected to the base of switching transistor $M_1$. The emitter of transistor $M_1$ is connected to ground ($V_{GG}$), and transistor $M_1$ contains a plurality of collectors $O_0$ through $O_3$. Each collector $O_0$ through $O_3$ of transistor $M_1$ may be connected to an input lead of another integrated injection logic gate, or may be left floating. For purposes of this specification, collectors $O_0$ through $O_2$ are shown floating, and only collector $O_3$ of transistor $M_1$ is shown connected to a subsequent integrated injection logic gate.

PNP injector transistor $T_2$ and NPN switching transistor $M_2$ comprise the second integrated injection logic gate of the circuit of Figure 1. The emitter of PNP transistor $T_2$ is connected to a voltage source $V_{EE}$ and the base of transistor $T_2$ is connected to ground $V_{GG}$. The collector of transistor $T_2$ is connected to collector $O_3$ of transistor $M_1$, thus receiving as an input signal the output signal provided by collector $O_3$ of transistor $M_1$. The collector of transistor $T_2$ is also connected to the base of switching transistor $M_2$. The emitter of NPN switching transistor $M_2$ is connected to ground. The collectors $P_0$ through $P_3$ of transistor $M_2$ provide a plurality of open collector outputs for connection to further logic gates or other circuitry if desired.

The operation of the prior art integrated injection logic circuit of Figure 1 is as follows. A positive voltage $V_{EE}$ is applied to the emitter of transistor $T_1$. The base of transistor $T_1$ and the emitter of transistor $M_1$ are connected to ground. The emitter-base junction of transistor $T_1$ is forward biased, thus turning transistor $T_1$ on. Thus, transistor $T_1$ supplies current from its emitter connected to $V_{EE}$ to its collector connected to the base of switching transistor $M_1$.

In actual operation, terminal 11 will not be floating but rather will receive a signal $V_{in}$ which will be either a logical one (effectively an open circuit, resulting in a high voltage on node $N_1$, typically 0.7 volts), or logical zero (effectively a short circuit, thus sinking the current made available at node $N_1$ by the collector of injector transistor $T_1$, resulting in a low voltage on node $N_1$, typically 0.1 volts). With a logical one applied to terminal 11, current is not drawn from the collector of $T_1$ to terminal 11. Thus the injector current made available by the collector of injector transistor $T_1$ is applied to the base and to the base-emitter junction of NPN transistor $M_1$, thereby turning on transistor $M_1$. Thus, transistor $M_1$ conducts when a logical one is applied to input terminal 11.

On the other hand, with a logical zero applied to input terminal 11, current will be drawn from the collector of injector transistor $T_1$ to terminal 11, thus depriving transistor $M_1$ of substantially all of the current supplied by injector transistor $T_1$. With the injector current from the collector of transistor $T_1$ sunk by the logical zero applied to input terminal 11, no current is available to forward bias the base-emitter junction of NPN transistor $M_1$, thereby causing transistor $M_1$ to remain off. Thus, transistor $M_1$ does not conduct when a logical zero is applied to input terminal 11.

PNP injector transistor $T_2$ operates in a manner similar to injector transistor $T_1$. A positive voltage $V_{EE}$ is applied to the emitter of transistor $T_2$, and its base is connected to ground ($V_{GG}$). Thus, the emitter-base junction of transistor $T_2$ is forward biased thus turning transistor $T_2$ on. With transistor $M_1$ conducting (logical one on input terminal 11), the current available from the collector of injection transistor $T_2$ is sunk through collector $O_3$ of transistor $M_1$ to ground (logical zero on node $N_2$), thus depriving transistor $M_2$ of base current, thereby maintaining transistor $M_2$ off. On the other hand, with transistor $M_1$ off (logical zero on input terminal 11), injector current supplied by transistor $T_2$ is not sunk by collector $O_3$ of transistor $M_1$, but rather provides the base current to transistor $M_2$. This base current flows from the base to the emitter of transistor $M_2$, thus turning transistor $M_2$ on.

In this manner, the circuit of Figure 1 allows a single input signal $V_{in}$ to generate a plurality of output signals to be applied to various gates and circuits as desired. For example, input signal $V_{in}$ provides four inverted signals on open collectors $O_0$ through $O_3$ which are applied to other circuits as desired. Furthermore, the inverted input signal available on collector $O_3$ of transistor $M_1$ is used to generate four non-inverted open collector signals on collectors $P_0$ through $P_3$ of transistor $M_2$. The fact that switching transistors $M_1$ and $M_2$ each are shown with a plurality of four collectors serves as an example only, and it is not to be interpreted that the switching transistors utilized in accordance with this invention must contain four collectors. In fact, a greater or lesser number of collectors may be utilized in accordance with well known semiconductor principles. However, as the number of collectors is increased, the capacitance of the device increases, thereby decreasing the switching speed of the circuit.

Furthermore, it is well known that a plurality of input signals may be connected to nodes $N_1$ and $N_2$ of Figure 1, thus providing for wired NAND logical operations on a plurality of input signals. For example, if a plurality of input terminals (not shown) are connected to node $N_1$ as is input terminal 11 of Figure 1, the signal on each input terminal connected to node $N_1$ must be a logical one to turn transistor $M_1$ on, thus grounding (logical zero) output leads $O_0$ through $O_3$ of transistor $M_1$. Conversely, a single logical zero on any input terminal connected to node $N_1$ will sink the injector current provided by transistor T, thus causing transistor $M_1$ to turn off and provide a logical one on output leads $O_0$ through $O_3$ of transistor $M_1$. Thus the additional input leads connected to node $N_1$ perform a wired NAND logic function.

One limitation of the prior art integrated injection logic circuits, such as the one shown in Figure 1, is that upon the creation of a high voltage (typically 0.7 volts) on input terminal 11 (i.e. when a logical one applied to input terminal 11), transistor $M_1$ turns on, thus decreasing the voltage on node $N_2$ to $V_{S1}$, where $V_{S1}$ is the collector-emitter voltage of transistor $M_1$ when $M_1$ is saturated. Similarly, with a low voltage (typically around 0.1 volts) applied to input terminal 11, transistor $M_1$ turns off, and the voltage on node $N_2$ is approximately $V_{EE}-V_{S2}$, where $V_{S2}$ is equal to the emitter-collector voltage of transistor $T_2$ when transistor $T_2$ is conducting. For typical $I^2L$ circuits, $V_{EE}=0.8$ volts, $V_{S1}=0.1$ volts, and $V_{S2}=0.1$ volts. Thus, the voltage on node 2 ranges from $V_{high}$ of approximately 0.7 volts (logical zero on input terminal 11, transistor $M_1$ non-conducting) to $V_{low}$ of approximately 0.1 volts (logical one on input terminal 11, transistor $M_1$ conducting). Thus, node $N_2$ experiences a rather large voltage swing (0.6 volts) between its logical zero and logical one states. This results in the prior art integrated injection logic circuit of Figure 1 being slow due to the time required to increase the charge on the capacitances of nodes $N_1$ and $N_2$ so as to change the voltages on these nodes from 0.1 volts to 0.7 volts when nodes $N_1$ and $N_2$ change from logical zero to logical one and the time required to decrease the charge on the capacitances of nodes $N_1$ and $N_2$ so as to change the voltages on these nodes from 0.7 volts to 0.1 volts when nodes $N_1$ and $N_2$ change from logical one to logical zero. Furthermore, the prior art $I^2L$ circuits such as the circuit of Figure 1 cause the switching transistors ($M_1$ and $M_2$ of Figure 1) to saturate when turned on, thus requiring a relatively large period of time to turn off and on as compared to transistors which are not operated in saturation.

The $I^2L$ circuit of Figure 1 has been modified to provide prior art $I^2L$ circuits with increased speed. For example, an article entitled "ISL, A Fast and Dense Low-Power Logic, made in a Standard Schottky Process" written by Lohstroh, IEEE Journal of Solid-State Circuits, Vol. SC-14, No. 3, June 1979, pages 585—590 describes integrated injection logic circuits utilizing Schottky diodes, and is hereby incorporated by reference. In Lohstroh's Figure 1, a plurality of Schottky diodes are connected in series with a single collector in order to drive a plurality of outputs. These Schottky diodes serve to reduce the voltage swing between high and low output signals as compared with the prior art $I^2L$ circuit of Figure 1. This arrangement does not prevent saturation of the switching transistor, and the output voltage swing between high and low states is temperature dependent and influenced by DC voltage offsets between sequential stages of logic. The circuit of Lohstroh's Figure 2 adds an additional Schottky diode to prevent saturation of the switching transistor. However, Lohstroh admits that this arrangement is not producible in a standard process, because two types of Schottky diodes are needed with different Schottky barrier heights. Furthermore, the circuit of Lohstroh's Figure 2 is temperature dependent and adversely influenced by DC voltage offsets between consecutive logic stages. The circuit of Lohstroh's Figure 3 provides a different technique to prevent saturation of the switching transistor. However, this circuit is also temperature dependent and adversely affected by the DC voltage offsets between consecutive logic stages.

An article by Peltier entitled "A New Approach to Bipolar LSI: $C^3L$", 1975 IEEE International Solid-State Circuits Conference, Friday, February 14, 1975, pages 168—169 describes yet another prior art integrated injection logic circuit, and is hereby incorporated by reference, Peltier's structure utilizes a plurality of Schottky diodes connected in series with a single collector to provide a plurality of outputs. Peltier utilizes a Schottky transistor as the switching transistor in order to provide a saturation voltage which is not as low as the saturation voltage of NPN switching transistors, as well as to minimize charge storage within the switching transistor. The Peltier circuit is also temperature dependent, and adversely affected by DC offset voltages between consecutive logic states.

FR—A—2 369 751 discloses an integrated injection logic circuit including an injection transistor feeding current to the base of a multi-collector switching transistor, and a Schottky diode connects a voltage source to the input of the switching transistor so as to prevent saturation of the latter.

The invention overcomes disadvantages of the prior art circuits, in particular of the circuit disclosed in the document just mentioned, in that the voltage swing between high and low states is limited to approximately 0.1 volts. The circuit of the invention is defined in claim 1.

It is to be noted that current mirror configurations are known per se from the document IEEE J. Solid State Circuits, Vol. SC-11, n-5, Oct. 1975, p. 644—647.

Such a current mirror limits the conducting current of the switching transistor and prevents, in cooperation with the voltage pull-up means, saturation thereof. This results in an increase in the voltage of conducting transistors corresponding to a logical zero, and thus in a decrease in the voltage swing between logical one and zero, thereby substantially increasing the speed of the circuit.

The voltage pull-up means connected to the input node of the injector transistors may comprise resistors or, preferably, forward biased Schottky diodes connected between a voltage source and the bases of the switching transistors.

Brief description of the drawings

Figure 1 is a schematic diagram of a prior art integrated injection logic circuit;

Figure 2 is a schematic diagram of an integrated injection logic circuit constructed in accordance with this invention;

Figure 3 is a graphical representation of the relationships between the voltage and current characteristics of one output collector of a switching transistor such as $M_1$ or $M_2$ of the integrated injection logic circuit of Figure 2;

Figure 4 is a schematic diagram of a circuit for providing a voltage $V_{dd}$ to the Schottky diodes utilized in the circuit of Figure 2; and

Figure 5 is a schematic diagram of a circuit constructed in accordance with this invention which utilizes metal-oxide-silicon transistors.

Detailed description

Figure 2 shows an integrated injection logic circuit constructed in accordance with this invention. Transistors $T_1$ and $T_2$ are shown as means for providing current to nodes $N_1$ and $N_2$, respectively, although other current sources (such as a resistor or a diode connected to a voltage source) may be utilized. Schottky diodes $D_1$ and $D_2$ are connected between terminal 13 and nodes $N_1$ and $N_2$, respectively. The collector $O_0$ of transistor $M_1$ is connected to the base of transistor $M_1$, and the collector $P_0$ of transistor $M_2$ is connected to the base of transistor $M_2$. Collectors $O_0$ and $P_0$ form current mirrors which serve to limit the current flow through collectors $O_1$ through $O_3$ and $P_1$ through $P_3$, as is more fully described below. It is believed that PN diodes may not be used in place of Schottky diodes $D_1$ and $D_2$ due to excessive minority carrier charge storage within the PN diode during forward bias, resulting in the rather slow switching speeds of PN diodes.

As a feature of this invention, a current mirror is formed by connecting one of the plurality of collectors of each switching transistor to its base (Figure 2). For example, collector $O_0$ of switching transistor $M_1$ is connected to the base of $M_1$. Similarly, the collecor $P_0$ of switching transistor $M_2$ is connected to the base of transistor $M_2$. Due to the high current gain or Beta of switching transistor $M_1$ (typically approximately 10—20), substantially all of the injector current supplied by injector transistor $T_1$ flows to the collector $O_0$ of transistor $M_1$ when a logical one (i.e. open circuit) is applied to input terminal 11. The current through collector $O_0$ in turn flows to the emitter of transistor $M_1$ which is grounded. This connection between the base of transistor $M_1$ and collector $O_0$ provides a relatively constant collector current $I_0$ through collector $O_0$. Collector current $I_0$ is determined by the magnitude of $V_{EE}$ (typically 0.8 volts), and the electrical characteristics of transistors $T_1$ and $M_1$. For a circuit fabricated with transistors of 0.5 microns by 0.5 microns per collector, preferably collector current $I_0$ is set at approximately 25 microamps in order to achieve a gate speed, with a fan out of four, of approximately 50 picoseconds. The base current, the base-emitter voltage of transistor $M_1$ and collector area determine the collector current of each of collectors $O_0$ through $O_3$ of transistor $M_1$. Because the base current and base-emitter voltage are the same with respect to each collector $O_0$ through $O_3$ of transistor $M_1$, the following equation defines the collector currents:

$$I_a/I_0 = A_a/A_0$$

where

$I_a$=the collector current of collector $O_a$, where a is an integer ranging from 1 to 3;

$I_0$=the collector current of collector $O_0$;

$A_a$=the collector area of collector $O_a$; and

$A_0$=the collector area of collector $O_0$. ·

Preferably the areas of collectors $O_1$ through $O_3$ are constructed to be twice the area of collector $O_0$. In this manner, the collector current capable of being sunk by each of collectors $O_1$ through $O_3$ is equal to $2I_0$.

In fact, the collector current $I_0$ of collector $O_0$ is equal to slightly less than the current supplied by the collector of injector transistor $T_2$, because a small portion $1/(1+\beta)$ of the current supplied by injector transistor $T_2$ forms the base current of transistor $M_2$. Here $\beta$ is the ratio of collector current to base current of transistor $T_2$. However, this difference is negligible and for the purposes of this specification it will be assumed that all the injector current supplied by the injector transistors $T_1$ and $T_2$ form the collector current of the current mirrors (collectors $O_0$ and $P_0$). Thus, while injector transistor $T_2$ supplies a current $I_0$ to node $N_2$ to turn transistor $M_2$ on, transistor $M_1$ (when on) sinks a current $2I_0$ from node $N_2$, thus causing transistor $M_2$ to turn off. Of this current $2I_0$ sunk by transistor $M_1$, half ($I_0$) is provided by injector transistor $T_2$ and half ($I_0$) is provided by Schottky diode $D_2$. Thus Schottky diode $D_2$ conducts, thus causing the voltage $V_{N2}$ on node $N_2$ to equal $V_{dd}$ (node 13) minus $V_{sk}$, (the voltage drop across a forward biased Schottky diode which is approximately 0.6 volts).

Terminal 13 is connected to a positive voltage supply $V_{dd}$, and serves to provide current to Schottky diodes $D_1$ and $D_2$ connected to nodes $N_1$ and $N_2$ respectively. Schottky diodes $D_1$ and $D_2$ limit the low voltage on nodes $N_1$ and $N_2$ by supplying current in addition to the current made available by injector transistors $T_1$ and $T_2$. Thus, when node $N_2$ is low the voltage on node $N_2$ is equal to $V_{low}$, where $V_{low}$ is equal to the voltage $V_{dd}$ applied to terminal 13 minus the forward biased voltage drop $V_{sk}$ of Schottky diode $D_2$. Thus, for example, utilizing Schottky diode $D_2$, the lower voltage limit of node $N_2$ is raised from $V_{s1}$, the collector-emitter saturation voltage of transistor $M_1$ (as previously described in conjunction with the prior art integrated injection logic circuit of Figure 1), to $V_{low}$. In this manner, the voltage swing between a logical one and a logical zero at nodes $N_1$ and $N_2$ is substantially reduced as compared with prior art $I^2L$ circuits. The reduced voltage swing between the two logic levels used in a binary logic circuit results in increased switching speed over prior art integrated injection logic circuits. Additional Schottky diodes are connected between $V_{dd}$ (terminal 13) and all other bases which are used as input terminals of all other switching transistors (e.g. bases to which collectors $O_1$ and $O_2$ of transistors $M_1$ and collectors $P_1$ and $P_2$ of transistor $M_2$ are connected) although these additional switching transistors and Schottky diodes are not shown in Figure 2. Collector $O_0$ and $P_0$ are not used as output terminals because they are used to form the current mirrors, as previously described. Thus, transistors $M_1$ and $M_2$ of the circuit of Figure 2 have a fan out of three. Node $N_1$ is connected to $V_{IN}$, which is typically made available on a switching transistor collector (not shown). Thus, Schottky diode $D_1$ serves to prevent saturation of the switching transistor (not shown) providing $V_{IN}$ connected to node $N_1$.

In the $I^2L$ circuit constructed in accordance with this invention having a fan in of four, the voltage $V_{low}$ is approximately 0.6 volts, and the voltage $V_{high}$ is approximately 0.7 volts. Thus, the voltage swing of nodes $N_1$ and $N_2$ between a logical one and a logical zero is approximately 0.1 volt, as compared with the voltage swing of approximately 0.6 volts of the integrated injection logic circuit of Figure 1. For circuits constructed in accordance with this invention having fan ins less than four, it is advantageous to use a voltage swing between logical states of as little as 0.05 volts (for a fan in of one) to further reduce power and increase speed. Conversely, for circuits constructed in accordance with this invention having fan outs greater than four, it is advantageous to use a voltage swing between logical states which is greater than 0.1 volts to provide increased noise immunity. However, this increase in voltage swing need not be great—for a fan out of eight, a voltage swing of 0.12 volts provides adequate noise immunity.

In one embodiment of this invention, Schottky diodes $D_1$ and $D_2$ are connected through terminal 13 to $V_{EE}$ (that is $V_{dd}$ is replaced by $V_{EE}$), the positive voltage supplied to the emitters of injector transistors $T_1$ and $T_2$. The connection of terminal 13 to $V_{EE}$ provides an integrated injection logic circuit in accordance with this invention having increased switching speed over the prior art integrated injection logic circuits. However, connecting Schottky diodes $D_1$ and $D_2$ (terminal 13) to $V_{EE}$ results in a circuit whose characteristics exhibit an undesirable change over operating temperature. For example, as the operating temperature of the device increases, the voltage swing between a logical zero and a logical one decreases. For a sufficiently low voltage swing between logic states, the circuit ceases to function. Furthermore, as the operating temperature of the device decreases, the voltage swing between a logical zero and a logical one increases, thus decreasing the speed of the device.

In order to eliminate the undesirable temperature characteristics which result when terminal 13 is connected to $V_{EE}$, a second embodiment of this invention connects terminal 13 to a second positive voltage source other than $V_{EE}$. For example, many integrated injection logic circuits derive their power from a voltage $V_{cc}$ of approximately 5 volts. From this 5 volt $V_{cc}$ supply suitable circuitry is utilized to generate various bias voltages, such as 5 volts for transistor-transistor logic (TTL) or approximately 0.8 volts for integrated injection logic ($I^2L$). This is typically how $V_{EE}$ is generated on a semiconductor chip, thus allowing the entire chip to be supplied by a single supply voltage $V_{cc}$. In the same manner, a voltage $V_{dd}$ may be generated from $V_{cc}$ and applied to terminal 13 to drive Schottky diodes $D_1$ and $D_2$. The voltage of $V_{dd}$ is typically (at room temperature) approximately 1.0 to 1.2 volts although any voltage capable of providing current to Schottky diodes $D_1$ and $D_2$ sufficient to make the voltage swing on nodes $N_1$ and $N_2$ approximately 0.1 volts between a logical high and a logical low is sufficient. When the semiconductor device contains a plurality of integrated injection logic gates, each gate will have with it an associated Schottky diode connected to $V_{dd}$.

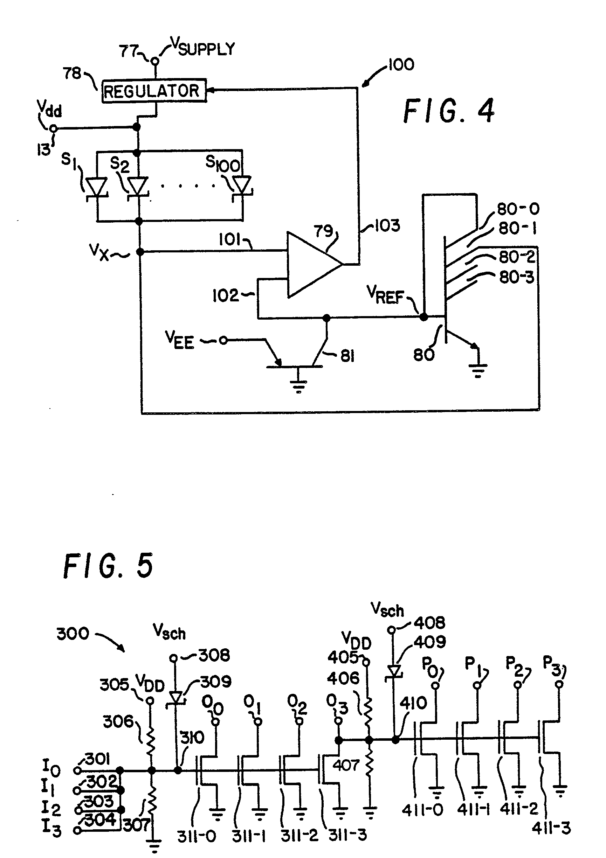

Figure 4 is the schematic diagram of a circuit which is used to provide voltage $V_{dd}$ on terminal 13, which corresponds with terminal 13 of Figure 2. Biasing circuit 100 comprises PNP injector transistor 81 having its base connected to ground ($V_{GG}$), its emitter connected to a positive voltage source $V_{EE}$, and its collector connected to the base of NPN transistor 80. NPN transistor 80 is identical to the switching transistors $M_1$ and $M_2$ of Figure 2 in order that the electrical characteristics of transistor 80 closely match the electrical characteristics of transistors $M_1$ and $M_2$. Similarly, PNP injection transistor 81 is identical PNP injection transistors $T_1$ and $T_2$ of Figure 2. PNP injection transistor 81 provides base drive to NPN transistor 80, thus forward biasing the base-emitter junction of NPN transistor 80, thereby turning on transistor 80. The emitter of transistor 80 is connected to ground ($V_{GG}$). Thus at 25°C the voltage $V_{REF}$ on the base of transistor 80 is equal to approximately 0.7 volts, the voltage drop across a forward biased PN junction. The collector 80-0 of transistor 80 is connected to the base of transistor 80. Because transistors 81 and $T_1$ and transistors 80 and $M_1$ are well matched, as previously described, a collector current flows through collector 80-O which is equal to the collector current $I_0$ flowing through the collector $O_1$ forming the current mirror of transistor $M_1$ (Figure 2). Because the area of collector 80-1 is twice the area of collector 80-0, collector 80-1 will sink $2I_0$, as previously described for the current mirror formed by collector $O_0$ of transistor $M_1$.

Voltage regulator 78 receives $V_{supply}$ as an input voltage to-be-regulated, and provides a regulated output voltage $V_{dd}$ in response to a feedback signal on lead 103 from comparator 79. Output terminal 13 of voltage regulator 78 is connected to the Schottky diodes $D_1$ and $D_2$ of Figure 2, as well as to the anodes of 100 Schottky diodes $S_1$, $S_2$, ... $S_{100}$ connected in parallel as shown in Figure 4. The use of 100 Schottky diodes $S_1$ through $S_{100}$ is a simple and inexpensive technique for providing a voltage $V_{dd}$ which results in a voltage swing on the collectors of the switching transistors (e.g. transistors $M_1$ and $M_2$ of Figure 2) of approximately 0.1 volt between a logical high (0.7 volts) and a logical low (0.6 volts), as is more fully explained below. The cathodes of Schottky diodes $S_1$, $S_2$ ... $S_{100}$ are connected to collector 80-1 of transistor 80. Because collector 80-1 of transistor 80 sinks $2I_0$, as previously described, a current equal to $2I_0$ is drawn from voltage regulator 78 through Schottky diodes $S_1$, $S_2$ ... $S_{100}$, through collector 80-1 to ground. The input lead 101 of voltage comparator 79 is connected to the cathodes of Schottky diodes $S_1$, $S_2$ ... $S_{100}$, and the input lead 102 of comparator 79 is connected to the base of transistor 80 (0.7 volts). The output lead 103 from voltage comparator 79 is connected to voltage regulator 78, thereby providing a feedback signal to voltage regulator 78 which in turn controls the voltage $V_{dd}$ on terminal 13. When the voltage $V_x$ on the cathodes of Schottky diodes $S_1$, $S_2$ ... $S_{100}$ exactly equals the voltage on the base of transistor 80 (0.7 volts), the signal on output lead 103 from comparator 79 is effectively equal to zero, and thus, the voltage $V_{dd}$ remains constant. If the voltage $V_x$ is greater than the voltage $V_{REF}$ on the base of switching transistor 80, a feedback signal is applied from lead 103 of comparator 79 to regulator 78, thus causing regulator 78 to decrease the voltage $V_{dd}$. On the other hand, if voltage $V_x$ is less than voltage $V_{REF}$, a signal will be applied from lead 103 of comparator 79 to regulator 78 causing regulator 78 to increase the voltage $V_{dd}$. In this manner, the voltage $V_x$ is regulated to be substantially equal to the voltage $V_{REF}$ (0.7 volts).

The current/voltage relationship of a PN junction is defined as:

$$I = I_x[\exp(qV/kT) - 1] \qquad (1)$$

where

$I$ = the current through the PN junction;
$I_x$ = the terminal current of charge carriers through the PN junction in either direction at zero bias;
$q$ = the charge of an electron ($1.60 \times 10^{-19}$ coulomb);
$V$ = the voltage across the PN junction;
$k$ = Boltzmann's constant ($1.38 \times 10^{-23}$ Joules/°K);
$T$ = temperature, in °K.
Thus, the voltage $V_{dd}$ is defined in the following equation:

$$2I_0/100 = I_x[\exp(q(V_{dd} - V_x)/kT) - 1] \qquad (2)$$

where

$2I_0/100$ = the current flow through each Schottky diode $S_1$, $S_2$ ... $S_{100}$; and
$V_x$ = the voltage on the cathodes of Schottky diodes $S_1$, $S_2$ ... $S_{100}$, which is regulated to equal 0.7 volts.

Similarly, the voltage/current relationship of a single Schottky diode (e.g. $D_2$ of Figure 2) connected between $V_{dd}$ and a collector of a switching transistor, when the switching transistor is turned on is defined as:

6

$$I_0 = I_x[\exp(q(V_{dd}-V_{low})/kT)-1] \tag{3}$$

where

$I_0$=the current through the Schottky diode $D_2$ which is sunk by the collector of the switching transistor; and

$V_{low}$=the (logical zero) voltage on node $N_2$ when switching transistor $M_1$ is conducting.

From equations (2) and (3):

$$[\exp(q(V_{dd}-V_{low})/kT)-1]=50[\exp(q(V_{dd}-V_x)/kT)-1] \tag{4}$$

or

$$V_{low}=0.7-(kT/q)\ln 49 \tag{5}$$

$$V_{low}\cong 0.6 \text{ volts at } 25°C \tag{6}$$

Thus, the voltage $V_{low}$ on the collectors of injector transistors $T_1$ and $T_2$ (Figure 2) when transistors $M_1$ and $M_2$ are conducting is equal to 0.6 volts, as compared with the low voltage of 0.1 volt in prior art $I^2L$ circuits. The switching transistors $M_1$ and $M_2$ of the $I^2L$ circuit constructed in accordance with this invention do not saturate, and the voltage swing at room temperature between a logical one and a logical zero is reduced from 0.6 volts in conventional prior art $I^2L$ circuits to 0.1 volt in the present invention. Furthermore, as seen from equation (5), the voltage swing between a logical one and a logical zero is equal to

$$V_{high}-V_{low}\cong (kT/q)\ln 49 \tag{7}$$

within the range of circuit operating temperatures. In this manner, circuit operating margins are preserved over temperature. In the embodiment of this invention shown in Figure 2, close regulation of currents is achieved by basic $I^2L$ techniques and by the use of current mirrors. Shunt pull-up diodes $D_1$ and $D_2$ limit the voltage swing between logical states, with the voltage swing being determined, as shown in equation (7), by the ratio of switching transistor collector current when the switching transistor is conducting to switching transistor collector current when the switching transistor is not conducting. The relation between the switching transistor currents when conducting and when not conducting therefore set circuit margins. For example, the ratio of the maximum switching transistor $M_1$ collector current $I_{o3MAX}$ (approximately $2I_0$) to the switching current of switching transistor $M_1$ ($I_0$) is equal to approximately $2I_0/I_0=2$ and is the margin by which switching transistor $M_1$ is held on and the voltage on node $N_2$ is held low. Similarly, the ratio of the switching current $I_0$ of switching transistor $M_1$ to the minimum current drawn from node $N_2$ through collector $O_3$ by outputs connected to node $N_2$ is the margin by which switching transistor $M_1$ is held off and the voltage on node $N_2$ held high. For the circuit of Figure 2, the ratio of switching current $I_0$ to minimum current drawn from collector $O_3$ through node $N_2$ when switching transistor $M_1$ is off is equal to $I_0/[(F_{in})(.02)(2I_0)]$ where $F_{in}$ is equal to the fan in, and $(.02)(2I_0)$ represents the current through collector $O_3$ through each input lead connected to node $N_2$ when node $N_1$ is at logical zero and switching transistor $M_1$ is turned substantially off. This current $(0.2)(2I_0)$ when switching transistor $M_1$ is turned off is described more fully below. Thus, this ratio is equal to 1/0.12 or approximately 8.3 when a fan in of 3 is used. In other words, these margins, expressed in terms of currents, are $(2I_0-I_0)=I_0$ and $(I_0-0.12I_0)=.88I_0$, respectively, for the high and low states of the voltage on node $N_2$. The temperature behavior of equation (7) exactly corresponds to the temperature behavior not only of thermal (Johnson) noise voltage but also of dynamic impedances of the connected junctions, thus tending to preserve noise margins over temperature.

Figure 3 is a graphical representation of the current $I_{o3}$ through collector $O_3$ of transistor $M_1$ for various voltages appearing on node $N_2$. In addition, the "static" components of the collector current $I_{o3}$ are shown. For example, $I_p$ shows the collector current which flows through collector $O_3$ in the prior art integrated injection logic circuit of Figure 1. The current $I_p$ is limited essentially to the collector current of injection transistor $T_2$. The line $I_{Schottky}$ shows the contribution to the collector current flowing through collector $O_3$ of the embodiment of this invention shown in Figure 3 due to the presence of Schottky diode $D_2$. The total current due to each of these two components is shown in the line labelled $I_{total}$. It is this current, $I_{total}$, which flows through collector $O_3$ up to the limit of $2I_0$ (approximately $2I_{pmax}$) as discussed previously.

The currents shown in Figure 3 are called "static" currents because they do not include currents which flow in order to change the charge stored in the capacitances of the circuit due to charging voltage levels during switching. For the purposes of this specification, it is to be understood that the currents represented in Figure 3 are these so-called "static" currents. As can be seen by the graphical representation of Figure 3, at high voltages (i.e. a logical one) on node $N_2$, the total collector current $I_{total}$ is formed primarily by the contribution due to the presence of prior art integrated injection logic circuit components. However, with a logical one on node $N_2$, the current $I_{total}$ is somewhat greater as compared with prior art $I^2L$ circuits because the switching transistor $M_1$ (Figure 2) is not turned completely off when node $N_1$ is at a logical zero. A logical zero on node $N_1$ corresponds to approximately 0.6 volts, as compared with a logical zero of approximately 0.1 volt in prior art $I^2L$ circuits. However, with a logical zero (0.6 volts) on the base of

switching transistor $M_1$, the collector current $I_p$ is equal to only approximately two percent (2%) of the maximum collector current $I_{sat}$ (i.e. with a logical one equal to 0.7 volts connected to the base of switching transistor $M_1$) per output lead connected to node $N_2$. For example, if two output leads are connected to node $N_2$ (from two separate logic gate outputs in a "wired NAND" configuration, previously described), sufficient base current to node $N_2$ is provided by the logical zero (0.6 volts) state of the two driving gates to cause a pull-down current at node $N_2$ which is equal to approximately four percent (4%) of the maximum collector current $I_{sat}$ which flows when transistor $M_1$ is saturated. However, this small current which flows when the driving gates are "off" does not adversely affect circuit operation.

When the voltage on node $N_1$ is increased from the low state to the high state, collector current $I_{03}$ of transistor $M_1$ increases, thus causing voltage $V_{n2}$ on node $N_2$ to decrease. As the voltage $V_{n2}$ on node $N_2$ decreases, additional shunt current is supplied by Schottky diode $D_2$, thus increasing the total collector current $I_{total}$ as compared with the saturated current $I_{sat}$ of collector $O_3$ of transistor $M_1$ which would flow in the circuit of Figure 1. In this manner, Schottky diode $D_2$ supplies current which is otherwise unavailable in a prior art integrated injection logic circuit, thus preventing the voltage $V_{n2}$ on node $N_2$ from decreasing to $V_{s1}$, the collector-emitter voltage of transistor $M_1$ when transistor $M_1$ is saturated. This increases the voltage on node $N_2$ when node $N_2$ is low level (logical zero) as compared with prior art $I^2L$ circuits. Due to the decrease in the voltage swing between logical one and the logical zero, the change of charge stored in the capacitance associated with node $N_2$ due to switching between a logical zero and a logical one is also decreased thereby providing increased switching speeds of the integrated injection logic circuit of this invention as compared with the switching speeds of prior art integrated injection logic circuits.

As shown in Figure 3, the use of Schottky diodes in accordance with this invention limits the low level voltage excursion of voltage $V_{n2}$ on node $N_2$. In prior art integrated injection logic circuits, when transistor $M_1$ of Figure 1 turns on, current equal to $I_{sat}$ flows from node $N_2$ through the collector $O_3$, thus resulting in a voltage $V_{s1}$ equal to approximately 0.1 volt on node $N_2$, where $V_{s1}$ is the saturation voltage of the collector-emitter voltage of $M_1$. Of importance, when Schottky diodes are utilized in accordance with this invention as in Figure 2, the low level (logical zero) voltage on node $N_2$ is limited (as shown in Figure 3) to

$$V_{low} = V_{dd} - V_{sk},$$

where

$V_{low}$ is the voltage associated with a logical zero;

$V_{dd}$ is the voltage applied to Schottky diodes via terminal 13; and

$V_{sk}$ is the forward bias voltage drop across Schottky diode $D_2$ with a current $I_0$ flowing through Schottky diode $D_2$, as previously described.

Thus, as previously described, the low level (logical zero) voltage $V_{low}$ on node $N_2$ is equal to approximately 0.6 volts. The high level (logical one) voltage $V_{high}$ on node $N_2$ is equal to $V_{EE} - V_{S2}$, because, in a similar manner as previously discussed with regard to the prior art circuit of Figure 1, node $N_2$ is not pulled down by the non-conducting transistor $M_1$. Thus, with $V_{EE} = 0.8$ volts and $V_{S2} = 0.1$ volts, a logical one on node $N_2$ is equal to approximately 0.7 volts.

The voltage swing on node $N_2$ between a logical high and a logical low is equal to $V_{high}$ minus $V_{low} = \Delta V$ which is approximately equal to 0.1 volts. In comparison, prior art integrated injection logic circuits provide a voltage swing on node $N_2$ equal to $V_{high}$ minus $V_{VS1}$ which is approximately equal to 0.6 volts.

The integrated injection logic circuit of this invention utilizing bipolar transistors consumes more power than prior art integrated injection logic circuits. The current consumption of an integrated injection logic circuit constructed in accordance with this invention is approximately twice as great as the current consumption of a prior art integrated injection logic gate utilizing approximately the same injector current supplied by the PNP injector transistor having its emitter connected to $V_{EE}$. The additional current consumption is due to the presence of one Schottky diode per gate. Utilizing small geometry, such as 0.5 micron line widths, integrated injection logic circuits may be constructed in accordance with this invention having switching speeds of approximately 50 to 100 picoseconds, while utilizing a fan-out of four, with an injector current of approximately 25 to 50 microamps per gate.

A circuit constructed in accordance with this invention, utilizing metal-oxide-silicon (MOS) transistors, is shown in Figure 5. Input terminals 301, 302, 303, and 304 receive input signals $I_0$, $I_1$, $I_2$ and $I_3$, respectively. Terminals $O_0$ through $O_3$ and $P_0$ through $P_3$ serve as open source output terminals which may be connected (as is terminal $O_3$) to other circuitry, as desired. A resistive voltage divider comprising resistors 306 and 307 is connected between terminal 305 connected to a voltage $V_{dd}$, and ground such that a fraction of the voltage $V_{dd}$ (denoted as $V_{high}$) is applied to input node 310. The voltage $V_{high}$ established by the voltage divider comprising resistors 306 and 307 provides the high level logic signal (arbitrarily defined as a logical "one") on input node 310. With logical ones applied to input terminals 301 through 304, the signal on node 310 is a logical one. On the other hand, if any signals $I_0$ through $I_3$ applied to input terminals 301 through 304 is a logical zero (low voltage), input node 310 is pulled down to that low voltage. In a manner similar to the circuit of Figure 2, Schottky diode 309 connected between terminal 308 and input node 310 limits the voltage on node 310 corresponding to a logical zero. Input terminal 308 is connected to a voltage supply $V_{sch}$ which is utilized to power the Schottky diodes of the circuit.

The voltage on input node 310 is connected to the gates of MOS switching transistors 311-0 through

# EP 0 085 624 B1

311-3, thus providing open source outputs $O_0$ through $O_3$, respectively. Each output terminal $O_0$ through $O_3$ may be connected to input nodes of additional logic gates, as desired. Furthermore, the number of switching transistors associated with each logic gate need not be four as shown in Figure 5, but may be any desired number consistent with good MOS semiconductor design practice.

Preferably the voltage $V_{low}$ corresponding to a logical zero is set to approximately 0.9 volts (corresponding to a $V_{sch}$ of approximately 1.4 volts, and the voltage $V_{high}$, corresponding to a logical one, is set to approximately 1.2 volts by $V_{dd}$ and resistors 306 and 307. This results in a voltage swing between a logical one and a logical zero of approximately 0.3 volts. This voltage swing is less than prior art MOS logic circuits designed for low voltage swings in which the logical one state is typically 1.5 volts and the logical zero state is typically 0 volts. As stated previously with respect to the logic circuit of Figure 2 which is constructed in accordance with the invention utilizing bipolar transistors, the reduced signal swing between the logical one and the logical zero will result in increased speed due to the reduced amount of time required to change the charge stored in the node capacitances of this circuit. Furthermore, the speed-power product of the circuit constructed in accordance with this invention utilizing MOS devices is less than the speed-power product of a comparable MOS logic circuit of the prior art.

An improved version of the circuit Figure 5 substitutes for resistor 307 an additional Schottky diode having its anode connected to input node 310 and its cathode connected to a second Schottky reference voltage, $V_{sch2}$. Similarly, resistor 407 is replaced by a Schottky diode having its anode connected to node 410 and its cathode connected to the reference voltage $V_{sch2}$. In this manner, the additional Schottky diodes establish the voltage $V_{high}$ corresponding to a logical one equal to $V_{sch2}$ plus one forward biased Schottky diode voltage drop. For a typical value of $V_{sch2}=0.7$ volts, and a forward biased Schottky diode voltage is equal to 0.5 volts, $V_{high}$ is equal to 1.2 volts.

The bias voltages $V_{sch}$ (connected to Schottky diodes 309 and 409) and $V_{sch2}$ (connected to the Schottky diodes replacing resistors 307 and 407 of Figure 5) can be set and controlled over a wide temperature range by the technique embodied in Figure 4, previously described in conjunction with the circuit constructed in accordance with this invention utilizing bipolar transistors.

While several embodiments of this invention have been disclosed in this specification, these embodiments are not limitations of the scope of this invention. Other embodiments will become apparent to those skilled in the art in light of this specification.

## Claims

1. An integrated injection logic circuit, comprising:
   means (T1) for providing an injection current,
   a switching transistor (M1) having a plurality of collectors ($O_0$, $O_1$, $O_2$) and an input node (N1) connected to said means for providing an injection current,
   voltage pull-up means ($V_{dd}$, D1) connected to said input node,
   and one ($O_0$) of said plurality of collectors being connected to the base of said transistor so as to form a current mirror limiting the current flow through each of said plurality of collectors.

2. The circuit of claim 1 wherein said pull-up means comprises a diode (D1) connected between a voltage source ($V_{dd}$) and said input node (N1).

3. The circuit of claim 1 or claim 2 wherein said switching transistor (M1) is a bipolar transistor.

4. The circuit of one of the preceding claims wherein the low and high voltages on said plurality of collectors ($O_0$, $O_1$, $O_2$) are equal to approximately 0.6 V and 0.7 V respectively.

5. The circuit of claim 2 wherein a first resistor is connected in parallel with said diode, and wherein said input node is connected via a second resistor to an additional voltage source.

6. The circuit of claim 2 wherein a resistor is connected in parallel with said diode, and wherein said input node is connected via an additional diode to an additional voltage source.

7. The circuit of one of claims 2, 5, or 6 wherein each diode is a Schottky diode.

## Patentansprüche

1. Ein integrierter Injektions-Logikschaltkreis, umfassend:
   Mittel (T1) für das Bereitstellen eines Injektionsstroms,
   einen Schalttransistor (M1) mit einer Mehrzahl von Kollektoren ($O_0$, $O_1$, $O_2$) und einen Eingangsknoten (N1), angeschlossen an die genannten Mittel für das Bereitstellen eines Injektionsstroms,
   Spannungshochziehmittel ($V_{dd}$, D1), angeschlossen an den genannten Eingangsknoten,
   und wobei einer ($O_0$) der genannten Mehrzahl von Kollektoren an die Basis des genannten Transistors angeschlossen ist, um so einen Stromspiegel zu schaffen, der den Stromfluß durch jeden der genannten Mehrzahl von Kollektoren begrenzt.

2. Der Schaltkreis nach Anspruch 1, bei dem die genannten Hochziehmittel eine Diode (D1) umfassen, angeschlossen zwischen einer Spannungsquelle ($V_{dd}$) und dem genannten Eingangsknoten (N1).

3. Der Schaltkreis nach Anspruch 1 oder Anspruch 2, bei dem der genannte Schalttransistor (M1) ein bipolarer Transistor ist.

9

4. Der Schaltkreis nach einem der vorangehenden Ansprüche, bei dem die niedrigen und hohen Spannungen an der Mehrzahl von Kollektoren ($O_0$, $O_1$, $O_2$) gleich etwa 0,6 V beziehungsweise 0,7 V sind.

5. Der Schaltkreis nach Anspruch 2, bei dem ein erster Widerstand der genannten Diode parallel geschaltet ist und bei dem der genannte Eingangsknoten über einen zweiten Widerstand an eine zusätzliche Spannungsquelle angeschlossen ist.

6. Der Schaltkreis nach Anspruch 2, bei dem ein Widerstand der genannten Diode parallel geschaltet ist und bei dem der genannte Eingangsknoten über eine zusätzliche Diode an eine zusätzliche Spannungsquelle angeschlossen ist.

7. Der Schaltkreis nach einem der Ansprüche 2, 5 oder 6, bei dem jede Diode eine Schottky-Diode ist.

**Revendications**

1. Circuit en logique d'injection intégrée comprenant:
—des moyens (T1) pour fournir un courant d'injection, un transistor de commutation (M1) ayant une pluralité de collecteurs ($O_0$, $O_1$, $O_2$) et un noeud d'entrée ($N_1$) relié audits moyens pour fournir un courant d'injection,
—des moyens tirant la tension vers le haut ($V_{dd}$, D1) relié audit noeud d'entrée et un ($O_0$) de ladite pluralité de collecteur étant relié à la base dudit transistor afin de former en miroir de courant limitant l'écoulement du courant à travers chacun de ladite pluralité de collecteur.

2. Circuit selon la revendication 1, dans lequel lesdits moyens tirant la tension vers le haut comprennent une diode (D1) reliée entre une source de tension ($V_{dd}$) et ledit noeud d'entrée (N1).

3. Circuit selon la revendication 1 ou 2, dans lequel ledit transistor de commutation (M1) est un transistor bipolaire.

4. Circuit selon l'une quelconque des revendications précédentes, dans lequel les tensions haute et basse sur ladite pluralité de collecteurs ($O_0$, $O_1$, $O_2$) sont respectivement égales à approximativement 0,6 volt et 0,7 volt.

5. Circuit selon la revendication 2, dans lequel une première résistance est reliée en parallèle avec ladite diode et dans lequel ledit noeud d'entrée est relié par l'intermédiaire d'une seconde résistance à une source de tension supplémentaire.

6. Circuit selon la revendication 2, dans lequel une résistance est reliée en parallèle avec ladite diode et dans lequel ledit noeud d'entrée est relié par l'intermédiaire d'une diode supplémentaire à une source de tension supplémentaire.

7. Circuit selon l'une des revendications 2, 5 ou 6, dans lequel chaque diode est une diode schottky.

FIG. 1

FIG. 2

FIG. 3

FIG. 4

FIG. 5

2